(19) Europäisches Patentamt
European Patent Office
Office européen des brevets

(11) EP 3 477 718 A1

(12) EUROPÄISCHE PATENTANMELDUNG

(43) Veröffentlichungstag:
**01.05.2019 Patentblatt 2019/18**

(21) Anmeldenummer: **17198596.3**

(22) Anmeldetag: **26.10.2017**

(51) Int Cl.:
***H01L 51/00*** *(2006.01)* ***H01L 35/24*** *(2006.01)*
***C08G 61/12*** *(2006.01)*

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder:
- **InnovationLab GmbH
69115 Heidelberg (DE)**
- **otego GmbH
76344 Eggenstein-Leopoldshafen (DE)**

(72) Erfinder: **Die Erfindernennung liegt noch nicht vor**

(74) Vertreter: **Schuck, Alexander
Patentanwälte
Isenbruck Bösl Hörschler PartG mbB
Eastsite One
Seckenheimer Landstraße 4
68163 Mannheim (DE)**

(54) **SIEBDRUCKFÄHIGE PEDOT ENTHALTENDE DRUCKPASTE ZUR HERSTELLUNG THERMOELEKTRISCHER GENERATOREN**

(57) Verfahren zur Herstellung einer Druckpaste enthaltend Poly(3,4-ethylendioxythiophen)-tosylat durch Polymerisation von Bis(3,4-ethylendioxythiophen) in Gegenwart von Eisen(III)-tosylat in einem organischen Lösungsmittel.

EP 3 477 718 A1

## Beschreibung

Die vorliegende Erfindung betrifft ein Verfahren zur Herstellung einer Druckpaste enthaltend Poly(3,4-ethylendioxythiophen)-tosylat, die Druckpaste selbst sowie deren Verwendung zur Herstellung von leitfähigen Filmen für thermoelektrische Generatoren durch Siebdruck.

Angetrieben durch die einfache Verarbeitung organischer Materialien und ihre gute synthetische Verfügbarkeit sind organische Dünnschichttransistoren sowie Anwendungen im Photovoltaik-Bereich ein Gebiet intensiver Forschung. Eine bisher wenig beachtete Methode alternativer Energieerzeugung ist die Möglichkeit, die Verlustwärme von beispielsweise Verbrennungsmotoren durch "energy harvesting" auszunutzen (R. C. Moreno, B. A. James, A. Navid, L. Pilon, Int. J. Heat and Mass Tran. 2012, 55, 4301; F. Y. Lee, A. Navid, L. Pilon, Appl. Therm. Eng. 2012, 37, 30). Dies ist mit sogenannten Thermoelektrischen Generatoren, kurz TEGs, möglich. TEGs können bei einer bestehenden Temperaturdifferenz ungenutzt fließende Verlustwärme in Nutzstrom umwandeln.

Alle kommerziell erhältlichen TEGs basieren auf anorganischen Materialien. Dotierte anorganische Leiter und Halbleiter, wie zum Beispiel Bismuttellurid, haben sich als effiziente TEG-Bestandteile erwiesen. Jedoch ist die Gewinnung der benötigten Elemente Bismut (Bi) und Tellur (Te) aufwändig und deren Vorkommen begrenzt. Außerdem sind metallische Materialien wegen ihrer schwierigen Verarbeitbarkeit in Fließbandprozessen für die Massenproduktion nur begrenzt tauglich. Auch die sehr gute Wärmeleitfähigkeit von Metallen beeinträchtigt deren Brauchbarkeit für TEGs.

Die Entwicklung von TEGs auf Basis organischer Materialien stellt eine attraktive Alternative dar. Die Speerspitze kommerziell verfügbarer, druckbarer organischer Halbleiter stellt derzeit das Material PEDOT:PSS (Poly(3,4-ethylendioxythiophen)-polystyrolsulfonat) dar. Organische Halbleiter wie PEDOT:PSS sind zum einen einfach verfügbar und zum anderen für Fließbandprozesse tauglich. Bisher stellten anorganische Materialien jedoch effizientere Materialien für thermoelektrische Anwendungen dar.

Der Seebeck-Effekt, auch thermoelektrischer Effekt genannt, wurde von Thomas Johann Seebeck im Jahre 1821 entdeckt. Er tritt auf, wenn zwischen zwei verschiedenen Metallen in einem Stromkreis eine Temperaturdifferenz angelegt wird. Die dabei entstehende Spannung kann mit Hilfe der Thermodiffusionsströme der Metalle erklärt werden. Am heißen Ende des Metalls befinden sich Elektronen höherer Energie und am kalten Ende weniger Elektronen geringerer Energie. Energiereiche Elektronen bewegen sich durch Diffusion entlang des chemischen Potentials vom warmen zum kalten Ende eines Temperaturgefälles und Elektronen mit niedriger Energie in die entgegengesetzte Richtung. Das entspricht einem diffusen Wärmetransport (Wärmeleitung) durch Elektronen. In diesem Zusammenhang wurde der Seebeck-Koeffizient $\alpha$ eingeführt. Durch ihn können vergleichbare Werte für leitende Materialien ermittelt werden.

Für den thermoelektrischen Effekt wird eine Temperaturdifferenz mit einem Wärmestrom benötigt. Der Carnot-Wirkungsgrad $\eta_C$ ist der höchste theoretisch erreichbare Wirkungsgrad, der bei der Umwandlung von Wärmeenergie in mechanische Arbeit oder elektrische Energie möglich ist, gemäß nachstehender Gleichung 1:

$$\eta_C = \frac{T_H - T_K}{T_H} = 1 - \frac{T_k}{T_H}$$

$T_H$ ist die Temperatur des heißen Beckens und $T_K$ die des kalten Beckens.
Für einen Thermogenerator, unter Einbeziehung von ZT, ergibt sich Gleichung 2 für den Wirkungsgrad $\eta$:

$$\eta = \eta_C \frac{\sqrt{1 + ZT} - 1}{\sqrt{1 + ZT} + T_K/T_H}$$

Der Wirkungsgrad von thermoelektrischen Generatoren setzt sich zum Teil aus dem Carnot-Wirkungsgrad zusammen, der ein thermodynamisches Limit darstellt. Der andere Teil bildet einen materialspezifischen Term, in den die Größe *ZT* eingeht (Gleichung 3). *Z* besitzt die Dimension *1/K* und wird als thermoelektrische Gütezahl bezeichnet. Das Produkt *ZT* ist dementsprechend dimensionslos. *ZT* hat sich als allgemeine Größe zur Vergleichbarkeit und Güte thermoelektrischer Materialien etabliert. Gleichung 3 zeigt, dass bei hohen Werten von *ZT* ein höherer Wirkungsgrad erreicht werden kann:

$$ZT = \frac{\alpha^2 \sigma T}{\kappa_{Ges}}$$

$\alpha$ ist der Seebeck-Koeffizient, $\sigma$ die elektrische Leitfähigkeit, *K* ist die thermische Leitfähigkeit. Diese Parameter sind alle materialabhängig und ein ideales thermoelektrisches Material verfügt über eine hohe elektrische Leitfähigkeit, einen

hohen Seebeck-Koeffizienten und eine niedrige thermische Leitfähigkeit. Bisherige Materialien erreichen jedoch nicht die Werte, die ein optimales thermoelektrisches Material hätte. Für anorganische Thermoelektrika beträgt $ZT$ = ca. 1 (z.B. für BiTe), für organische Materialien liegt ZT eine Größenordnungen darunter (M. Scholdt, H. Do, J. Lang, A. Gall, A. Colsmann, U. Lemmer, J. Koenig, M. Winkler, H. Boettner, J. Electron. Mater. 2010, 39, 1589).

Isolatoren besitzen hohe Seebeck-Koeffizienten, jedoch eine sehr niedrige elektrische Leitfähigkeit. Das daraus resultierende $Z$ ist klein. Somit sind Isolatoren ungeeignet als thermoelektrische Materialien. Metalle hingegen sind sehr gute elektrische Leiter, besitzen aber auch eine sehr hohe thermische Leitfähigkeit. Zusätzlich sind die Seebeck-Koeffizienten von Metallen klein, weswegen sie für effiziente TEGs ungeeignet sind. Somit kommen als thermoelektronische Materialien nur Halbleiter oder Halbmetalle in Frage. Diese haben das beste Verhältnis aus moderater thermischer Leitfähigkeit $K$, moderater elektrischer Leitfähigkeit $\sigma$ und moderatem Seebeck-Koeffizienten $\alpha$.

Poly(3,4-ethylendioxythiophen) (PEDOT) wurde im Jahre 1988 ausgehend von 3,4-Ethylendioxythiophen erstmals synthetisiert. Die Bandbreite leitfähiger organischer Polymere ist groß. Ein Extrem ist Polyacetylen (PAc), dessen durch Dotierung mit Iod maximierte elektrische Leitfähigkeit von 100.000 S/cm an die Leitfähigkeit von Metallen heranreicht. Diese Werte für die Leitfähigkeit sind bis heute Referenz-Niveau, jedoch geht die sehr hohe Leitfähigkeit auf Kosten der Prozessierbarkeit. Intensive Forschung nach besser prozessierbaren und unempfindlicheren leitfähigen organischen Polymeren führte schließlich von Polyanilinen über Polypyrrolen zu Polymeren auf Thiophenbasis.

Vielseitige Modifikationen des Thiophenrückgrats an den Positionen C-3 und C-4 durch Alkyl- oder Alkoxysubstituenten führten schließlich zum Monomer 3,4-Ethylendioxythiophen (EDOT), welches den Markt der organischen elektrischen Halbleiter seit ca. 25 Jahren dominiert (A. Elschner, S. Kirchmeyer, W. Lovenich, U. Merker, K. Reuter, PEDOT: principles and applications of an intrinsically conductive polymer, 2010, CRC Press). Um elektrisch leitfähiges PEDOT zu erhalten, muss dieses p-dotiert werden. Generell kann EDOT durch verschiedene Oxidationsmittel wie $Fe^{3+}$, $Ce^{4+}$, $Cu^{2+}$ oder $Mn^{4+}$ sowohl polymerisiert als auch dotiert werden, so dass automatisch durch oxidative Polymerisation dotiertes PEDOT erhalten wird (S. G. Im, D. Küsters, W. Choi, S. H. Baxamusa, M. C. M. van de Sanden, K. K. Gleason, ACS Nano 2008, 2, 1959; G. D. Wolff, J. F., R. Schomaecker, EP 707 440, 1994). Der Dotierungsgrad hängt dann vom verwendeten Überschuss des Oxidationsmittels ab.

Gemäß nachstehendem Schema 1 werden 2.33 Äquivalente an Eisen(III)tosylat verwendet. 2.00 Äquivalente werden benötigt, um ein neutrales Polymer zu erhalten, während die überschüssigen 0.33 Äquivalente für die Dotierung sorgen. Als Gegenionen haben sich neben Chlorid, Chlorat, Nitrat, Sulfat vor allem Polystyrolsulfonat (PSS) sowie Toluensulfonat, kurz Tosylat (Tos) durchgesetzt. Die Gegenionen werden benötigt, um den Ladungsausgleich des positiv geladenen PEDOTs zu gewährleisten. Durch Variation des Gegenions, bei gleicher Polymerisationsart, können die Leitfähigkeiten zwischen 8 - 130 S/cm schwanken (J. Xia, N. Masaki, M. Lira-Cantu, Y. Kim, K. Jiang, S. Yanagida, J. Phys. Chem. C 2008, 112, 11569).

Schema 1: Polymerisation von EDOT zu undotiertem PEDOT mit anschließender p-Dotierung.

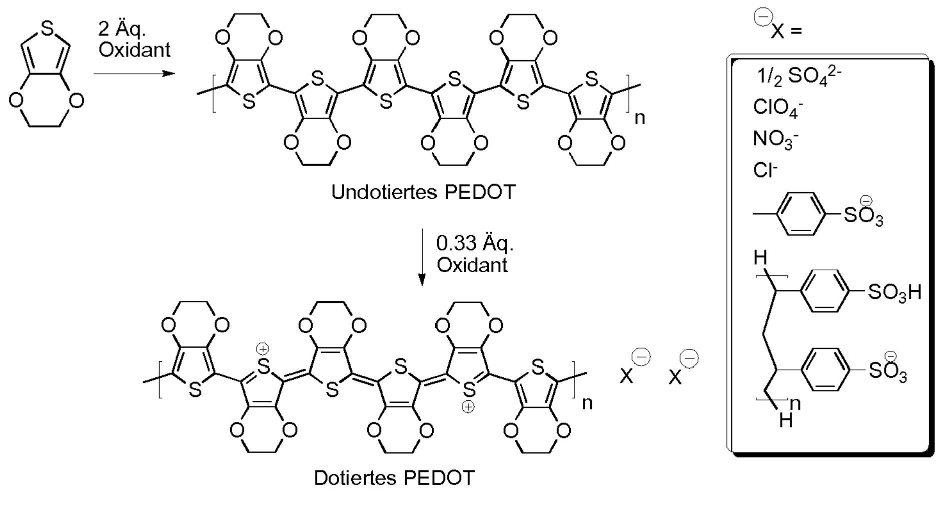


Kommerziell in gebrauchsfertiger prozessierbarer Form wird bisher nur PEDOT:PSS vertrieben. Da PEDOT:PSS in Form einer Dispersion vorliegt, ist es sehr einfach und vielseitig einsetzbar. Die Herstellung einer PEDOT:PSS-Dispersion ist in EP 0 686 662 A2 beschrieben. Dabei wird eine wässrige Lösung von PSS ($M_n$~40.000) mit Kaliumperoxodisulfat und katalytischen Mengen an Eisen(III)-sulfat mit EDOT versetzt und bei Raumtemperatur 24 h

gerührt (Schema 2). Anschließend wird durch Zugabe von Kationen- und Anionentauscherharzen das Reaktionsgemisch aufgereinigt. Die so erhaltene Flüssigkeit ist tiefblau und hat einen Feststoffgehalt von ca. 1,2 Gew.-%.

Schema 2: PEDOT:PSS-Darstellung nach EP 0 686 662 A2.

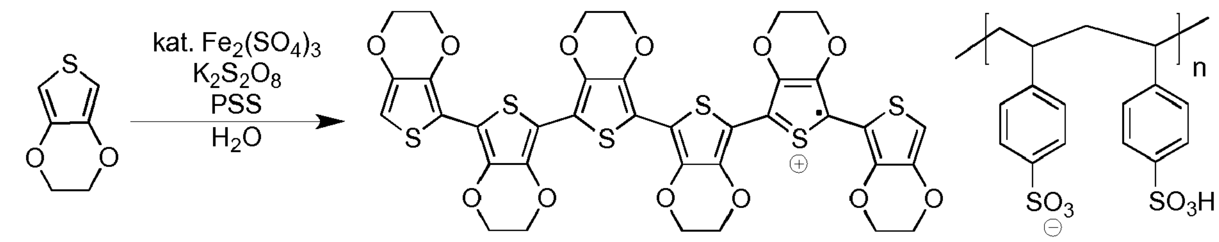


Bei den erhältlichen PEDOT:PSS-Dispersionen handelt es sich um Flüssigkeiten, die mittels Rotationsbeschichtung aufgebracht werden können. Nach der Trocknung wird ein hellblauer, semitransparenter, leitfähiger Film erhalten. Verschiedene PEDOT:PSS-Varianten werden von der Fa. Heraeus unter dem Markennamen Clevios™ vertrieben. Clevios™ PH 1000 weist eine theoretische Leitfähigkeit von bis zu 850 S/cm und ein PEDOT:PSS-Verhältnis von 1:2.5 auf und ist bis dato das leitfähigste PEDOT enthaltende Material (M. Vosgueritchian, D. J. Lipomi, Z. Bao, Adv. Funct. Mater. 2012, 22, 421).

Die Effizienz von TEGs lässt sich anhand ihres ZT-Wertes vergleichen. Anfänglich lagen die ZT-Werte von PEDOT:PSS bei ca. 0.0001 (M. Scholdt, H. Do, J. Lang, A. Gall, A. Colsmann, U. Lemmer, J. Koenig, M. Winkler, H. Boettner, J. Electron. Mater. 2010, 39, 1589). Intensive Optimierungsarbeiten führten zum bisherigen Bestwert für PEDOT:PSS von ZT = 0.42. Dieser wurde von Pipe et al. durch schrittweises Einwirken von Ethylenglykol (EG) auf PEDOT:PSS-Filme erreicht (G. Kim, L. Shao, K. Zhang, K. P. Pipe, Nat. Mater. 2013, 12, 1). Durch das Einwirken von hydrophilem Ethylenglykol (EG) wird langsam hydrophiles PSS aus dem Film herausgelöst, wobei hydrophobes PEDOT im Film verbleibt. Dieser Prozess wird auch allgemein als dedoping bezeichnet, da PSS als dopand (Dotierungsmittel) fungiert (S. Jönsson, J. Birgerson, X. Crispin, G. Greczynski, W. Osikowicz, A. Denier van der Gon, W. Salaneck, M. Fahlman, Synthetic Met. 2003, 139, 1). Neben eventuellen strukturellen Änderungen innerhalb des PEDOT:PSS-Films erfolgt eine Aufkonzentrierung des PEDOT-Gehaltes. Der Grad an elektrischer Dotierung wird vermutlich nicht geändert.

Poly(3,4-ethylendioxythiophen)-tosylat (PEDOT:Tos) kann aus den kommerziell erhältlichen Lösungen Baytron C und Baytron M der Clevios™-Produktpalette hergestellt werden. Baytron M enthält EDOT, während Baytron C aus einer 40 %igen $FeTos_3$-Lösung in Butanol besteht. Die Mischung von Baytron C und Baytron M reagiert äußerst schnell zu PEDOT und muss schnell verarbeitet werden. In der Literatur wird die Halbwertszeit dieser Mischung mit ca. 10 bis 20 min angegeben (B. Winther-Jensen, K. West, Macromolecules 2004, 37, 4538). Diese Darstellungsweise von PEDOT:Tos wird häufig auch als *in situ*-Polymerisation bezeichnet.

Durch basische Inhibitoren wie Imidazol und Pyridin kann die Halbwertzeit dieser Mischung deutlich erhöht werden (B. Winther-Jensen, D. W. Breiby, K. West, Synthetic Met. 2005, 152, 1). Imidazol sorgt sogar dafür, dass die Polymerisation unter VPP-Bedingungen (Vapour Pressure Polymerisation) erst stattfindet, wenn es bei ca. 105 °C verdampft ist. Diese optimierten Verfahren liefern PEDOT-Filme mit Leitfähigkeiten von bis zu 1000 S/cm.

Das entstehende Eisen(II)-tosylat kristallisiert während der Polymerisation von PEDOT aus und beeinflusst dadurch die Morphologie des entstehenden Films negativ.

Murphy et al. beschrieben im Jahre 2009 den positiven Einfluss von statistischem Ethylenglykol-Propylenglykol-Copolymer (PEG-ran-PPG) als Additiv, welche zu Leitfähigkeiten von bis zu 1000 S/cm führte (M. Fabretto, M. Müller, K. Zuber, P. Murphy, Macromol. Rapid Commun. 2009, 30, 1846). PEG-ran-PPG ($M_w$~12.000 Da) hat neben der Inhibition der Eisensalz-Kristallisation auch den positiven Effekt, dass es das Oxidationspotential von Eisen(III)-tosylat senkt, was zu einer geringeren Polymerisationsrate führt.

O. Bubnova, Z. U. Khan, A. Malti, S. Braun, M. Fahlman, M. B. X. Crispin, Nat. Mater. 2011, 10, 429 verwendeten PEDOT:Tos-Filme, die mittels Rotationsbeschichtung erhalten wurden, und reduzierten diese chemisch stufenweise mit TDAE zur thermoelektrischen Optimierung von PEDOT:Tos. Dabei wurde PEDOT in verschiedenen Dotierungsstufen von 15 bis 40 % erhalten und für jeden Reduktionsschritt die Leitfähigkeit und der Seebeck-Koeffizient bestimmt.

PEDOT:Tos ist für die Entwicklung eines organischen thermoelektrischen Materials interessanter als PEDOT:PSS, da damit durch Rotationsbeschichtung (engl. spin coating) Filme mit sehr hohen elektrischen Leitfähigkeiten von über 1000 S/cm erzeugt werden können.

Kim et al. zeigten eine in situ-Polymerisation von EDOT-Monomeren durch Eisen(III)-tosylat als Oxidationsmittel (T. Park, C. Park, B. Kim, H. Shin, E. Kim, Energ. Environ. Sci. 2013, 6, 788). Zusätzlich wurde neben Pyridin auch das

Triblock-Copolymer PEPG (Poly(ethylenglykol)-*block*-poly(propylenglykol)-blockpoly(ethylenglykol)) mit einer mittleren Molmasse ($M_n$) von 2800 als Additiv eingesetzt. Dieses Additiv senkt das Oxidationspotential von Eisen(III) und wirkt zusätzlich der Kristallisation von Eisen(II)-tosylat entgegen, welches die Morphologie des entstehenden PEDOT-Filmes stören würde. Mit Filmen, die nach dieser Methode erstellt wurden, erreichten Park et al. einen ZT-Wert von 1.02 durch die gezielte elektrochemische Reduktion bzw. Oxidation der PEDOT:Tos-Filme (T. Park, C. Park, B. Kim, H. Shin, E. Kim, Energ. Environ. Sci. 2013, 6, 788). Dabei fungierte eine $Ag/Ag^+$-Elektrode als Referenz. Die durch in situ-Polymerisation erstellten PEDOT:Tos-Filme wurden mit den Additiven Pyridin und PEPG-Copolymer ($M_n$~2800) erzeugt. Elektrochemisch unbehandelte Proben wiesen Leitfähigkeiten von bis zu 1362 S/cm auf.

Aufgabe der Erfindung ist es, ein verbessertes Verfahren zur Herstellung von PEDOT enthaltenden, mittels Siebdruckverfahren verdruckbarer Druckpasten zur Herstellung von Thermoelektrischen Generatoren bereitzustellen.

Gelöst wird die Aufgabe durch ein Verfahren zur Herstellung einer mittels Siebdruck verdruckbaren Druckpaste enthaltend Poly(3,4-ethylendioxythiophen)-tosylat (PEDOT:Tos) durch Polymerisation von Bis(3,4-ethylendioxythiophen) (BiEDOT) in Gegenwart von Eisen(III)-tosylat in einem organischen Lösungsmittel.

Durch die Polymerisation von BiEDOT zu PEDOT in Gegenwart von Eisen(III)-tosylat wird die Menge an Oxidationsmitel gegenüber der Polymerisation von 3,4-Ethylendioxythiophen (EDOT) zu PEDOT um 50 % reduziert.

Schema 3: EDOT vs. BiEDOT Oxidationsmittelverbrauch

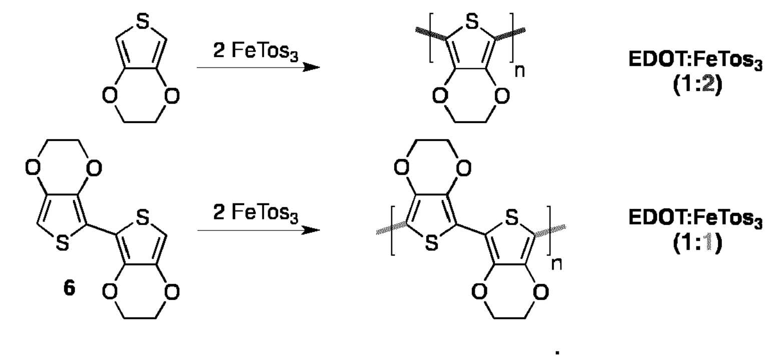


BiEDOT kann, wie in T. M. Swager, R. Kingsborough, S. S. Zhu, US 6 323 309 B1, 2001 sowie G. A. Sotzing, J. R. Reynolds, P. J. Steel, Adv. Mater. 1997, 9, 795 beschrieben, nach einer Variante der Ullmann-Kupplung durch Deprotonierung von EDOT bei -78°C mit n-Butyllithium und anschließender Zugabe einer stöchiometrischen Menge an $CuCl_2$ hergestellt werden. Nach Aufwärmen von -78°C auf 40°C und weiterem Rühren des Reaktionsgemischs, beispielsweise für weitere 2 h, kann nach Aufreinigung durch Filtration über Silica und Celite BiEDOT mit Ausbeuten von 32 - 56 % als gelblicher Feststoff isoliert werden.

Da entstandenes Kupfer an Luft recht schnell zur entsprechenden Kupfer(II)-Verbindung oxidiert, bildet sich aufgrund der Reaktivität von BiEDOT innerhalb kurzer Zeit PEDOT und die Ausbeute der Reaktion nimmt dadurch ab. Einengen des Reaktionsgemisches mit anschließender Zugabe von Dichlormethan und Wasser erhöht die Ausbeute.

BiEDOT kann weiterhin mit hoher Ausbeute durch Eisen(III)acetylacetonat induzierte EDOT-Kupplung hergestellt werden, wie von T. M. Swager, R. Kingsborough, S. S. Zhu in US 6,323,309 B1 (2001) beschrieben. Dabei wurde mit n-Butyllithium in THF EDOT deprotoniert und zu einer siedenden Eisen(III)acetylacetonat-Lösung in THF zugegeben.

Geeignete organische Lösungsmittel, in denen erfindungsgemäß BiEDOT zu PEDOT polymerisiert werden kann, sind Chloroform, Dichlormethan, Acetonitril, Anisol, Essigsäureethylester, Tetrahydrofuran, m-Xylol und Mesitylen, bevorzugt sind Acetonitril, Anisol und Essigsäureethylester, besonders bevorzugt ist Methoxybenzol (Anisol). Chlorierte Lösungsmittel und leicht entzündliche Lösungsmittel wie THF werden in Druckprozessen nur in Ausnahmefällen angewandt. Ein bevorzugtes Lösungsmittel für Eisen(III)-tosylat sind Anisol-Isopropanol-Gemische.

BiEDOT kann erfindungsgemäß direkt auf einem Substrat in situ polymerisiert werden. Vorzugsweise werden beide Lösungen auf Raumtemperatur gebracht und wird die BiEDOT-enthaltende Lösung zu der Eisen(III)-tosylat enthaltenden Lösung gegeben. Es wird eine viskose, tiefblaue Masse erhalten. Die Viskosität entspricht dem kommerziellen Produkt Clevios™ S V4 von Heraeus, einer siebdruckfähigen PEDOT:PSS-Formulierung.

Im Allgemeinen enthält die erfindungsgemäß hergestellte, PEDOT:Tos enthaltende Druckpaste ein polymeres Bindemittel als filmbildendes Additiv. Geeignete Bindemittel sind in organischen Lösungsmitteln gut löslich und ergeben bei Raumtemperatur kratzfeste Filme. Das Bindemittel soll dem getrockneten Film eine gute Stabilität verleihen und sicherstellen, dass keine sichtbaren Brüche an der Oberfläche auftreten.

Geeignete polymere Bindemittel sind Polyethylenoxid (PEO), vorzugsweise mit einem zahlenmittleren Molekulargewicht $M_n \sim 100.00$ bis 9.000.000 und Polyvinylpyrrolidon (PVP), beispielsweise mit einem zahlenmittleren Molekulargewicht $M_n \sim 1.300.000$. PEO und PVP liefern hitzebeständige, flexible, farblose Filme.

Das polymere Bindemittel kann vor dem Vermischung der BiEDOT enthaltenden Lösung und der Eisen(III)-tosylat enthaltenden Lösung einer oder beiden Lösungen zugegeben werden. Vorzugsweise wird das polymere Bindemittel in Mengen von 50 bis 100 Gew.-%, bezogen auf die Menge an BiEDOT, eingesetzt. Das Verhältnis von PEDOT : Bindemittel in der fertigen Druckpaste ist somit vorzugsweise maximal 1 : 1 und damit deutlich niedriger als das entsprechende Verhältnis von 1 : 2.5 in PEDOT : PSS.

Somit ist Gegenstand der vorliegenden Erfindung auch ein Verfahren zur Herstellung einer mittels Siebdruck verdruckbaren Druckpaste enthaltend Poly(3,4-ethylendioxythiophen)-tosylat (PEDOT:Tos) durch Polymerisation von Bis(3,4-ethylendioxythiophen) (BiEDOT) in Gegenwart von Eisen(III)-tosylat in einem organischen Lösungsmittel, wobei dem Poly(3,4-ethylendioxythiophen)-tosylat (PEDOT:Tos) ein polymeres Bindemittel als filmbildendes Additiv zugegeben wird.

In dem Film verbleibendes, nicht leitendes Material wie Eisen(II)-tosylat, Copolymer Polyethylenoxid mit $M_v$ 100.000 oder auch PEPG-Copolymer mit $M_n > 2000$ und bei der Polymerisation entstehende p-Toluensulfonsäure (PTSA) können die Leitfähigkeit des erhaltenen Films beeinträchtigen. Daher wird das durch Polymerisation erhaltene PEDOT:Tos-Gemisch vorzugsweise in einem Waschschritt vor dem Verfilmen aufgereinigt.

Der Waschschritt kann durch Extrahieren des PEDOT und Tosylat erhaltenen Reaktionsgemischs mit Wasser erfolgen, sofern eine gute Phasenseparation des organischen Lösungsmittels, in dem die Polymerisation von BiEDOT zu PEDOT durchgeführt wird, von Wasser gegeben ist. In einer Ausführungsform der Erfindung wird ein Gemisch aus Wasser und Ethylenglykol (EG), insbesondere ein 1:1-Gemisch aus Wasser und Ethylenglykol, als Extraktionsmittel eingesetzt. Dieses Extraktionsmittel wird insbesondere dann verwendet, wenn die Polymerisation in einem Anisol enthaltenden organischen Lösungsmittel, vorzugsweise einem Anisol-Isopropanol-Gemisch, durchgeführt wird.

Durch das Extraktionsmittel werden PTSA und Eisen(III)- sowie Eisen(II)-Salze aus dem bei der Polymerisation erhaltenen Reaktionsgemisch herausextrahiert.

Die gute Phasenseparation macht es möglich, PEDOT:Tos durch Filtration von überschüssigem Lösungsmittel abzutrennen. Es resultiert eine homogene Masse ohne überstehende Lösemittelreste.

Eine Aufreinigung von PEDOT:Tos kann auch durch Zugabe von Anionen- und Kationenaustauscherharze durchgeführt werden, wie dies in der Literatur für die Aufreinigung von PEDOT:PSS beschrieben ist. Dabei wird eine wässrige Suspension erhalten, wobei das Ionenaustauscherharz mittels Filtration abgetrennt wird. Bei der erfindungsgemäßen Filtration befindet sich das leitfähige Material PEDOT:Tos jedoch nicht im Filtrat, sondern im feuchten Filterkuchen. Da das PEDOT:Tos im Filter verbleibt, stellt die Filtration eine attraktive Variante dar, um aufgereinigtes PEDOT:Tos zu erhalten. Durch wiederholte Extraktion kann PEDOT:Tos weiter aufgereinigt werden.

Somit ist Gegenstand der vorliegenden Erfindung auch ein Verfahren zur Herstellung einer mittels Siebdruck verdruckbaren Druckpaste enthaltend Poly(3,4-ethylendioxythiophen)-tosylat (PEDOT:Tos) durch Polymerisation von Bis(3,4-ethylendioxythiophen) (BiEDOT) in Gegenwart von Eisen(III)-tosylat in einem organischen Lösungsmittel, wobei das Reaktionsgemisch der Polymerisation anschließend mit einem Extraktionsmittel extrahiert wird.

In einer bevorzugten Ausführungsform ist das Extraktionsmittel ein Ethylenglykol-Wasser-Gemisch, beispielsweise ein 1:1-Gemisch.

In einer bevorzugten Ausführungsform wird das polymere Bindemittel als filmbildendes Additiv dem PEDOT:Tos erst nach dem Extraktionsschritt zugegeben. Im Allgemeinen wird zusätzlich noch ein Lösungsmittel zugegeben, beispielsweise Isopropanol.

Somit ist Gegenstand der vorliegenden Erfindung auch ein Verfahren zur Herstellung einer mittels Siebdruck verdruckbaren Druckpaste enthaltend Poly(3,4-ethylendioxythiophen)-tosylat (PEDOT:Tos) durch Polymerisation von Bis(3,4-ethylendioxythiophen) (BiEDOT) in Gegenwart von Eisen(III)-tosylat mit den Schritten:

(i) Polymerisation von Bis(3,4-ethylendioxythiophen) (BiEDOT) in Gegenwart von Eisen(III)-tosylat in einem organischen Lösungsmittel,
(ii) Extraktion des in Schritt (i) erhaltenen Reaktionsgemischs mit einem Extraktionsmittel,
(iii) Abtrennung von Poly(3,4-ethylendioxythiophen)-tosylat (PEDOT:Tos) von dem in Schritt (ii) erhaltenen Gemisch als Feststoff,
(iv) Zugabe eines polymeren Bindemittels und gegebenenfalls eines weiteren Lösungsmittels zu dem abgetrennten Feststoff.

Vorzugsweise ist das in Schritt (i) verwendete organische Lösungsmittel ein Anisol-Isopropanol-Gemisch. Vorzugsweise ist das in Schritt (ii) eingesetzte Extraktionsmittel ein Ethylenglykol-Wasser-Gemisch. Vorzugsweise ist das in Schritt (iv) eingesetzte polymere Bindemittel ein Polyethylenoxid. Vorzugsweise ist das in Schritt (iv) eingesetzte weitere Lösungsmittel Isopropanol.

Gegenstand der vorliegenden Erfindung ist auch eine Druckpaste enthaltend

a) 1 bis 7 Gew.-%, bevorzugt 3 bis 7 Gew.-% Poly(3,4-ethylendioxythiophen)-tosylat,
b) 0,01 bis 2 Gew.-% eines polymeren Bindemittels als filmbildendes Additiv,
c) 81 bis 98,99 Gew.-%, bevorzugt 81 bis 96,99 Gew.-% eines organischen Lösungsmittels
d) 0 bis 10 Gew.-% weiterer Bestandteile,

wobei die Summe der Komponenten a) bis d) 100 Gew.-% ergibt.

Weitere Bestandteile sind Nebenprodukte der Polymerisation wie Eisen(II)-tosylat, Eisen(III)-tosylat, Bis-(3,4-Ethylendioxythiophen), nicht leitfähige Bis-(3,4-Ethylendioxythiophen)-Oligomere, Anisol, Isopropanol, Polyethylenoxid ($M_v$ 100.000) die im Extraktionsschritt (ii) nicht vollständig abgetrennt wurden.

In einer bevorzugten Ausführungsform ist das polymere Bindemittel a) ein Polyethylenoxid. In einer weiteren bevorzugten Ausführungsform ist das organische Lösungsmittel b) Isopropanol. Gegenstand der vorliegenden Erfindung ist auch die Verwendung der Druckpaste zur Herstellung von leitfähigen Filmen für thermoelektrische Generatoren. Im Allgemeinen wird die Druckpaste dazu mittels Siebdruck auf ein Substrat aufgebracht.

Für das Layout eines TEG ist eine gedruckte Schichtdicke im Mikrometer-Bereich vorteilhaft. Dabei ist der Siebdruck die Drucktechnik der Wahl, da die Nassfilmschicht bei Wahl eines groben Siebes auch mehrere Mikrometer dick aufgetragen werden kann.

Beim Siebdruck wird die Druckertinte mit einer wischerähnlichen Rakel aus Gummi durch ein strukturiertes, feinmaschiges Sieb gedrückt. Die Drucktinte bleibt auf der zu bedruckenden Oberfläche haften und löst sich aus dem Sieb heraus. Wichtig bei der Auswahl des Siebs ist, dass die Maschengröße an die Viskosität der Drucktinte angepasst ist. Der Vorteil des Siebdruckverfahrens gegenüber anderen gängigen Methoden ist die Möglichkeit vergleichsweise dicke Nassfilmschichtdicken zu erzeugen, was dem Design von TEGs entgegenkommt.

Die Erfindung wird durch die nachstehenden Beispiele näher erläutert.

Beispiele

Beispiel 1

Für eine Variante der Ullmann-Kupplung wurde EDOT bei -78°C mit n-Butyllithium deprotoniert und anschließend stöchiometrische Mengen an $CuCl_2$ zugegeben. Nach Aufwärmen von -78°C auf 40°C wurde das Reaktionsgemisch noch weitere 2 h gerührt. Nach Aufreinigung durch Filtration über Silica und Celite konnte BiEDOT mit Ausbeuten von 32 bis 56 % als gelblicher Feststoff isoliert werden.

Die Aufreinigung des BiEDOT-Kupfer-Gemisches ist problematisch, das entstandene Kupfer oxidiert an Luft recht schnell zur entsprechenden Kupfer(II)-Verbindung. Aufgrund der Reaktivität von BiEDOT bildet sich innerhalb kürzester Zeit PEDOT und die Ausbeute der Reaktion nimmt dadurch rapide ab. Einengen des Reaktionsgemisches mit anschließender Zugabe von Dichlormethan und Wasser erhöhte die Ausbeute. Die Charakterisierung erfolgte mittels $^1$H-Spektroskopie, wobei ein Singulett der zwei Thiophenwasserstoffe bei 6.27 ppm und die Multipletts der 8 Wasserstoffe des Ethylendioxyrückgrates zwischen 4.22 bis 4.25 ppm und 4.31 bis 4.34 ppm die Synthese von BiEDOT nachwiesen.

Beispiel 2

Neben dem vorstehend beschriebenen Syntheseweg wurde auch die in US 6,323,309 angegebene, Eisen(III)-Acetylacetonat induzierte EDOT-Kupplung durchgeführt. Dabei wurde mit n-Butyllithium in THF EDOT deprotoniert und zu einer siedenden Eisen(III)-Acetylacetonat-Lösung in THF kanüliert. Die Ausbeute betrug 64 %.

Beispiel 3

BiEDOT ist im direkten Vergleich zu EDOT schlechter in unpolaren Lösungsmitteln löslich (Tabelle 1). In einem qualitativen Löslichkeitstest überzeugte Methoxybenzol (Anisol), wobei BiEDOT in hohen Konzentrationen erst bei ca. 100°C in Lösung geht. Chlorierte und leicht entzündliche Lösungsmittel wie Chloroform oder THF wurden nicht weiter verwendet, da sie für die Anwendung in einem Druckprozess nur in Ausnahmefällen verwendet werden sollten.

Tabelle 1: Qualitativ überprüfte Löslichkeiten von BiEDOT

| Lösungsmittel | Löslichkeit |
|---|---|
| Chloroform | Sehr gut |

(fortgesetzt)

| Lösungsmittel | Löslichkeit |
|---|---|
| Dichlormethan | Sehr gut |
| Acetonitril | Gut |
| Anisol | Gut |
| Essigester | Gut |
| Tetrahydrofuran | Gut |
| m-Xylol | Mäßig |
| Mesitylen | Mäßig |
| 2-Propanol | Schlecht |
| Cyclohexan | Schlecht |
| Diethylether | Schlecht |
| Methanol | Schlecht |
| 1,5-Butandiol | Unlöslich |
| Petrolether | Unlöslich |

Eisen(III)-tosylat geht bei der gewählten Konzentration von ca. 230 mg/mL in einem heißen Anisol-Alkohol-Gemisch in Lösung. Deswegen wurde BiEDOT in einem Anisol-Alkohol-Lösungsmittelgemisch gelöst, um mit ähnlichen Gemischen an Lösungsmitteln zu arbeiten.

BiEDOT sollte nach der Methode nach Park et al. direkt auf einem Objektträger in situ polymerisiert werden (T. Park, C. Park, B. Kim, H. Shin, E. Kim, Energ. Environ. Sci. 2013, 6, 788). Sobald beide Lösung gebrauchsfertig bei Raumtemperatur waren, wurde die BiEDOT-Lösung zur Eisen(III)-Lösung gegeben. Jedoch wurde statt einer orangefarbenen, rotationsbeschichtbaren Lösung sofort eine viskose tiefblaue Masse erhalten. Die Viskosität entspricht dem kommerziellen Produkt Clevios™ S V4 von Heraeus, einer siebdruckfähigen PEDOT:PSS-Formulierung. Erfolgte die Zugabe der Eisen(III)-Lösung zur BiEDOT-Lösung, führt dies offenbar zu einer unvollständigen Reaktion, wofür eine Gelbfärbung während der Trockung der Oberfläche spricht.

Die erhaltene tiefblaue PEDOT:Tos-Masse wurde mit einer selbst erstellten einfachen Rakelapparatur auf einen Objektträger aufgerakelt. Die Mischung wurde mit einem Spatel auf den Rand eines Objektträgers aufgebracht und mit einem zweiten Objektträger wurde die viskose Masse über den Objektträger gezogen. Eine ausreichende Höhe des Nassfilmes wurde durch unterlegte Deckgläser gewährleistet.

Beispiel 4

Es wurde eine Testreihe mit jeweiliger Erhöhung der Äquivalente an Oxidationsmittel durchgeführt (Tabelle 2). Als einziges Additiv wurde Pyridin zur Eisen(III)-Lösung zugegeben. Nachdem die BiEDOT-Lösung zur Eisen(III)-tosylatlösung zupipettiert wurde, trat sofort Blaufärbung ein und innerhalb weniger Sekunden wurde eine viskose Masse erhalten. Die Proben wurden nach dem Rakeln für 45 min auf 70°C erhitzt. Anschließend wurden sie in ein Ethanolbad gelegt und danach für 15 min bei 70°C getrocknet.

Tabelle 2: Einfluss Oxidationsmitteläquivalente ohne Copolymer mit Ethanolbad

| Eintrag | $FeTos_3$ [Äq.] | Schichtdicke [$\mu$m] | Leitfähigkeit [S/cm] |
|---|---|---|---|
| 1 | 2.0 | 19.1 | 0.04 |
| 2 | 2.25 | 21.6 | 0.10 |
| 3 | 2.50 | 20.0 | 0.24 |
| 4 | 2.75 | 24.7 | 0.59 |
| 5 | 3.00 | 23.2 | 0.96 |

Die erhaltenen Oberflächen wiesen alle sichtbaren Brüche auf, dadurch kann die schlechtere Leitfähigkeit erklärt werden. Trotz dieser unzureichenden Oberflächenvernetzung war eine deutliche Steigerung der Leitfähigkeit von 0.035 S/cm um das 27-fache auf 0.96 S/cm zu erkennen, welche auf Erhöhung der Eisen(III)-äquivalente von 2.0 auf 3.0 zurückzuführen ist.

Beispiel 5

In einer weiteren Testreihe mit jeweiliger Erhöhung der Äquivalente an Oxidationsmittel wurde der Einfluss des Copolymers PEPG ($M_n$~2800) untersucht. Dazu wurde, angelehnt an Park et al., das Copolymer zur Eisen(III)-tosylat-Lösung gegeben (Tabelle 3). Die Proben wurden nach dem Rakeln für 45 min auf 50°C erhitzt. Ausgewählte Proben wurden anschließend mit Ethanol gewaschen und für 20 min bei 70°C getrocknet.

Tabelle 3: Einfluss von Waschlösung, Äquivalente an Oxidationsmittel und Copolymer auf Schichtdicke und Leitfähigkeit.

| Eintrag | $FeTos_3$ [Äq.] | Schichtdicke [μm] | Leitfähigkeit [S/cm] |
|---|---|---|---|
| 1 | 2.25 | 3.9 | 6.23 |
| 2 | 2.50 | 3.1 | 8.56 |
| 3 | 2.75 | 3.3 | 21.16 |
| 4 | 3.00 | 3.6 | 16.16 |
| 5 | 2.25 | 15.3[a)] | 2.97[a)] |
| 6 | 2.50 | 17.2[a)] | 2.68[a)] |
| 7 | 2.75 | 24.3[a)] | 1.83[a)] |
| 8 | 3.00 | 12.1[a)] | 2.71[a)] |
| [a)]Ohne Ethanolbadbehandlung | | | |

Wie erwartet stieg die Leitfähigkeit mit angenommenem höherem Dotierungsgrad an. Im direkten Vergleich ohne Copolymer-Zusatz bewirkte die Zugabe des PEPG-Copolymers ($M_n$~2800) eine enorme Steigerung der Leitfähigkeit.

Durch ausgewaschene Nebenprodukte wie Eisen(II)-tosylat, PTSA und PEPG-Copolymer ($M_n$~2800) nahm die Schichtdicke in diesem Experiment im Schnitt um 79 % ab. Nicht abgespülte Oberflächen wiesen eine wachsartige Konsistenz auf, welche auf das flüssige PEPG-Copolymer-Additiv ($M_n$~2800) zurückzuführen ist.

Beispiel 6

Die anfänglichen Experimente mit den BiEDOT-Gemischen zeigten, dass die Proben mit niedriger Viskosität attraktiv wären, um sie in einem Druckprozess einzusetzen. Problematisch waren jedoch die brüchigen Oberflächen und die daraus resultierenden geringen Leitfähigkeiten.

Es wurde ein ausführliches Screening mit verschiedenen polymeren Bindern durchgeführt. Die Binder sollten bei Raumtemperatur kratzfeste Filme ergeben und sich in organischen Lösungsmitteln gut lösen. Dadurch sollte der getrocknete Film eine gute Stabilität und keine sichtbaren Brüche der Oberfläche aufweisen.

Zunächst wurde die Löslichkeit von Polymethylmethacrylat (PMMA), Vinylec E, Polyethlyenglykolmethylether (PEGME, $M_n$~2000), PEO (Polyethylenoxid, $M_v$~100.00 bis 9.000.000) und PVP (Polyvinylpyrrolidon, $M_n$~1.300.000) in Anisol getestet. PMMA stellte sich als ungeeignet bezüglich dessen Löslichkeit in Anisol heraus. Vinylec E löste sich zwar in Anisol, hinterließ beim Entfernen des Lösemittels jedoch einen nicht hitzebeständigen, gelblichen Film. PEGME hinterließ einen nicht hitzebeständigen farblosen Film. PEO und PVP hingegen lieferten gute, hitzebeständige, flexible farblose Rückstände. Somit wurden weitere Experimente vor allem mit PEO ($M_v$~100.000) durchgeführt.

Die Binder wurden vor der Vermischung der beiden Komponenten in die jeweiligen Lösungen gegeben. Dabei wurden Mengen von 50 bis 100 % des zusätzlichen Binders, bezogen auf BiEDOT verwendet. Das Verhältnis von PEDOT:Binder ist somit maximal 1:1 und damit deutlich unter dem Verhältnis von 1:2.5 des PEDOT:PSS. Das daraus resultierende viskose PEDOT:Tos-Reaktionsgemisch wurde mit einem Spatel auf den Objektträger aufgetragen und anschließend bei ca. 100°C auf einer Heizplatte bis zur vollständigen Trockene erhitzt. Die Oberflächenbeschaffenheit wurde unter Anderem unter einem Mikroskop begutachtet. Gröbere Risse bzw. Brüche konnten auch mit bloßem Auge gesehen werden. Um den Einfluss des Binders auf die Leitfähigkeit zu untersuchen, wurden halbquantitative Messungen

mit Hilfe des sogenannten Flächenwiderstandes durchgeführt. Dazu wurden mit Silberleitlack Silber-Elektroden auf ein ausgekratztes, ca. 0.5 x 0.5 cm großes PEDOT-Quadrat aufgetragen, und mit einem Multimeter wurde der Widerstand bestimmt.

Diese Oberflächenscreenings sollten vor allem dazu dienen eine Größenordnung für die Menge an Binder zu bekommen, die dem PEDOT:Tos-Gemisch beigegeben werden sollte um die Oberflächeneigenschaften zu verbessern. In Tabelle 4 sind einige ausgewählte Beispiele gezeigt.

Tabelle 4: Auswahl aus dem Screening polymerer Binder

| Eintrag | Additiv | Beobachtung | $\Omega/cm^2$ |
|---|---|---|---|
| 1 | PVP | Oberfläche mit wenig Brüchen | 207 |
| 2 | PEPG / Vinylec F | Schlechte Löslichkeit | 120 |
| 3 | PEGME / PEO | Oberfläche mit wenig Brüchen | 70 |
| 4 | PEPG / PEO | Oberfläche mit wenig Brüchen | 50 |

PEO stellte sich als bestes Bindemittel bezüglich Oberflächenfestigkeit, Löslichkeit und Einfluss auf den Flächenwiderstand heraus. PVP ist ebenfalls ein guter Binder, bewirkte jedoch eine deutliche Zunahme des Flächenwiderstandes.

Beispiel 7

Um vergleichbare Ergebnisse bezüglich der Leitfähigkeit zu bekommen, musste die viskose Masse gleichmäßig auf ein Substrat aufgetragen werden.

Dazu wurden 7 x 4 cm große Blöcke aus Polyoxymethylen-Copolymer (POM-C) mit Einkerbungen definierter Tiefen von 0.07, 0.13, 0.27 und 0.56 mm angefertigt. Damit konnte das PEDOT:Tos-Gemisch reproduzierbar als eine 5 mm breite Linie auf einen gereinigten Objektträger gerakelt werden.

Mit dem verbesserten Rakelprozess konnten Kombinationen von Additiven anhand der erzielten Leitfähigkeiten verglichen werden. Es wurden jeweils 20 mg BiEDOT und 90 mg $FeTos_3$ in einem Anisol-Butanol- bzw. Anisol-Isopropanol-Gemisch mit den jeweiligen Additiven umgesetzt (Tabelle 5). Die Additive wurden jeweils, falls nicht anders gekennzeichnet, aufgeteilt und in beiden Lösungen zu gleichen Teilen gelöst.

Tabelle 5: Leitfähigkeiten der gerakelten PEDOT:Tos-Gemische mit Additiven

| Eintrag | Additiv A [mg] | Additiv B [mg] | A:B | Schichtdicke [μm] | Leifähigkeit [S/cm] |
|---|---|---|---|---|---|
| 1[c)] | 150 PEPG ($M_n$~5800) | - | - | 36.4[a)] | 5.2 |
| 2d) | 100 PEPG ($M_n$~8400) | 14 PEO ($M_v$~100.000) | 7:1 | 54.6 (0.56)[b)] | 6.1 |
| 3[d)] | 100 PEPG ($M_n$~14600) | 14 PEO ($M_v$~100.000) | 7:1 | 32.6 (0.27)[b)] | 4.2 |
| 4d) | 10 PEPG ($M_n$~14600) | 10 PEO ($M_v$~600.000) | 1:1 | 25.6 (0.27)[b)] | 7.3 |
| 5[d)] | 10 PEPG ($M_n$~14600) | 8 PEO ($M_v$~600.000)<br>8 PEO ($M_v$~100.000) | 5:4 | 87.3 (0.56)[b)] | 1.4 |
| 6[c)] | 100 PEGME ($M_n$~2000) | 20 PEO ($M_v$~100.000) | 5:1 | 28.5[a)] | 2.9 |
| 7 | 50 PEGME ($M_n$~2000) | 3 PEO ($M_v$~100.000)<br>2 PEO ($M_v$~300.000)<br>2 PEO ($M_v$~600.000) | 7:1 | 9.9 3.0[e)] (0.13) | 5.6 13.9[e)] |

[a)]Mit Spatel aufgetragen
[b)]Einkerbungstiefe des verwendeten Spachtelrakel in mm
[c)]An isol-Butanol-Gemisch;
[d)]Anisol-Isopropanol-Gemisch
[e)]Nach Ethanolwäsche

Die erhaltenen Filme weisen einen niedrigen Flächenwiderstand von 30 bis 180 $\Omega/cm^2$ auf. Im Film verbleibendes, nichtleitendes Material wie Eisen(II)-tosylat, Copolymer und die bei der Polymerisation entstehende PTSA

wurde nicht ausgewaschen. Dadurch liegt die Oberflächendicke in Bereichen von 28 bis 80 μm und beeinflusst die Leitfähigkeiten negativ, die sich zwischen 1.4 und 7.3 S/cm bewegen (Tabelle 5). Eine Probe wurde kurz in einem Ethanolbad gewaschen. Danach lag die Leitfähigkeit bei 13.9 S/cm. Die Schichtdicke nahm dadurch um 60 % von 9.9 μm auf 3.0 μm ab und zeigt deutlich, dass der große Anteil an nichtleitendem Material problematisch ist. Nachbehandlungsschritte zur Aufreinigung mit Ethanol wurden nicht weiter untersucht, da dies für den Druckprozess unpraktikabel ist. Aus diesem Grund sollte das PEDOT:Tos-Gemisch vor dem eigentlichen Druckprozess aufgereinigt werden.

Beispiel 8

Das Nachbehandeln der erzeugten Filme mit Ethanol zur Entfernung der Nebenprodukte der Polymerisierungsreaktion ist in der Praxis in einem Fließbandprozess kostenintensiv und schwer zu implementieren. Aus diesem Grund ist eine einsatzfertige PEDOT-Lösung ohne ionische Verunreinigungen wünschenswert. Daher wurde das PEDOT:Tos Gemisch vor dem Verfilmen gereinigt.

Zu dem viskosen Reaktionsgemisch wurde etwas destilliertes Wasser gegeben und geschüttelt. Die Waschlösung wurde abpipettiert und danach mittels pH-Papier und rotem bzw. gelbem Blutlaugensalz, als Eisen(II) bzw. Eisen(III)-Nachweis, qualitativ untersucht. Die qualitativen Untersuchungen zeigten, dass das Waschwasser PTSA und Eisen(III)- sowie Eisen(II)-Salze enthielt. Die Phasenseparation von Wasser und PEDOT:Tos in der organischen Phase stellte sich jedoch als problematisch heraus, da ein Anisol-Wasser-Gemisch zu einer milchigen Suspension führte. Mischungsexperimente mit Ethylenglykol zeigten eine bessere Phasenseparation, die beste Phasenseparation lieferte ein 1:1-Gemisch aus Ethylenglykol (EG) und Wasser. Darauf folgend wurden PEDOT:Tos-Gemische mit den Additiven PEGMME ($M_n$~2000) und PEO ($M_v$~600.00) hergestellt und anschließend durch einen Waschprozess aufgereinigt (Tabelle 6).

Tabelle 6: Einfluss der Vorbehandlung mit EG:$H_2O$ auf die Leitfähigkeit und Schichtdicke von PEDOT:Tos (Einkerbungstiefe des verwendeten Spachtelrakel 0.13 mm)

| Eintrag | Additiv [mg] | Waschprozess | Schichtdicke [μm] | Leitfähigkeit [S/cm] |
|---|---|---|---|---|
| 1 | 100 PEGMME ($M_n$~2000) | 1x $H_2O$ : EG (1:1) | 7.3 | 5.6 |
| 2 | 10 PEO ($M_v$~600.000) | 1x $H_2O$ : EG (1:1) | 4.6 | 19.0 |

Die gute Phasenseparation machte es möglich, PEDOT:Tos direkt von der Oberfläche abzuschöpfen. Jedoch war das so erhaltene Material noch mit überschüssigem Anisol getränkt. Das überständige Anisol ließ sich nicht komplett durch Filtration entfernen, sondern musste abpipettiert werden. Daraus resultierte eine nahezu homogene Masse ohne überständige Lösemittelreste. Vom abgeschöpften und filtrierten PEDOT:Tos wurden Filme angefertigt und deren Leitfähigkeit gemessen. Allein durch die Filtration konnte die Leitfähigkeit von 22.8 S/cm auf sehr gute 91.7 S/cm gesteigert werden (Tabelle 7).

Tabelle 7: Ergebnisse der gewaschenen PEDOT:Tos-Mischung

| Eintrag | Spachtelrakel [mm] | Schichtdicke [μm] | Leitfähigkeit [S/cm] |
|---|---|---|---|
| 1 | 0.13 | 1.0 | 13.8[a)] |
| 2 | 0.13 | 0.9 | 22.8[a)] |
| 3 | 0.13 | 1.1 | 16.9[a)] |
| 4 | 0.13 | 2.2 | 82.9[b)] |
| 5 | 0.07 | 1.5 | 91.7[b)] |
| [a)]Abgeschöpftes PEDOT:Tos;<br>[b)]Restflüssigkeit über Filtration und Pipettieren entfernt | | | |

Die Filtrationsmethode ist neu und führt dazu, dass sich das leitfähige Material nicht im Filtrat, sondern im feuchten Filterkuchen befindet. Daher stellt die Filtration eine attraktive Variante dar, um "reines" PEDOT:Tos zu erhalten. So muss kein Ionenaustauscher eingesetzt werden, sondern es kann einfach über eine wiederholte Extraktion weiter aufgereinigt werden.

Beispiel 9

Nachteilig an durch Extraktion erhaltenem "reinen" PEDOT:Tos ist dessen schlechte filmbildende Eigenschaft. Mit großer Wahrscheinlichkeit wurden die zugesetzten wasserlöslichen polymeren Binder beim Waschschritt teilweise in die wässrige Phase ausgespült. Um die filmbindenden Eigenschaften zu verbessern wurden, bezogen auf BiEDOT, 5 Gew-% PEO ($M_v$~100.000) in Isopropanol mit einer Konzentration von 8 mg/mL zum "reinen" PEDOT:Tos gegeben. Die erhaltene grob disperse, viskose, tiefblaue Mischung stellte das druckfertige PEDOT:Tos dar.

Dabei wies das PEDOT:Tos-Gemisch mit ca. 14.5 % den höchsten Feststoffgehalt auf, jedoch beinhaltete dieses die anorganischen Eisensalze. Das aufgereinigte PEDOT hatte mit ca. 9 % immer noch einen hohen Feststoffanteil. Nach Zugabe des Additivs und Verdünnung mit Isopropanol belief sich der Feststoffgehalt auf ca. 6.4 %.

Beispiel 10

Mit dieser optimierten PEDOT:Tos-Darstellungsmethode konnte abschließend noch der Einfluss der Waschlösung getestet werden. Dazu wurde je ein Ansatz PEDOT:Tos-Gemisch mit verschiedenen Mengen Waschlösung (50 mL, 100 mL und 250 mL) extrahiert. Eine Probe wurde zweimal mit 50 mL aufgereinigt. Alle Proben wurden jeweils über Nacht bei 500 rpm gerührt. Nach Filtration wurde das erhaltene "reine" PEDOT:Tos mit je ca. 0.3 mL Isopropanol aufgeschlämmt und 0.25 mL Isopropanol mit 2 mg PEO ($M_v$~100.000) zugegeben (c = 8 mg/mL; entspricht 5 Gew.-% PEO bezogen auf BiEDOT). Die Ergebnisse der Leitfähigkeitsmessungen sind in Tabelle 8 zusammengefasst

Tabelle 8: Einfluss der Waschprozesse auf die Leitfähigkeit und Schichtdicke (Einkerbungstiefe des verwendeten Spachtelrakel 0,13 mm)

| Eintrag | Waschprozess [EG/$H_2O$] | Schichtdicke [$\mu$m] | Leitfähigkeit [S/cm] |
|---|---|---|---|
| 1 | 1x 50 mL | 2.9 | 89.4 |
| 2 | 1x 100mL | 2.1 | 116.4 |
| 3 | 2x 50 mL | 1.8 | 124.6 |
| 4 | 1x250 mL | 1.6 | 107.4 |

Durch das Vergrößern des Waschvolumens stieg die Leitfähigkeit des PEDOT:Tos-Films an. Das Ergebnis mit 50 mL Waschlösung ist deutlich unter 100 S/cm. Nach zwei Waschvorgängen mit je 50 mL zeigte sich eine deutliche Steigerung der Leitfähigkeit.

Beispiel 11

Parallel zum Einfluss der Waschlösungsmenge wurden Dotierungsexperimente unter Erhöhung der Äquivalente an Oxidationsmittel durchgeführt. Die Polymerisationslösungen wurden anschließend jeweils mit Ethylenglykol : Wasser (1:1, 15 mL auf einen 80 mg BiEDOT Ansatz) versetzt und über Nacht gerührt (Tabelle 9). Nach Filtration wurde das "reine" PEDOT:Tos wieder mit PEO ($M_v$~100.00, 5 Gew.-% bezogen auf BiEDOT) versetzt. Nach dem Auftragen auf einen Objektträger wurde die Oberfläche mit einer Heizpistole 5 - 15 s lang bis zur Wischfestigkeit erhitzt. Neben der Leitfähigkeit wurde zusätzlich auch noch der Seebeck-Koeffizient gemessen. Dadurch lässt sich der *"powerfactor"* $\alpha^2\sigma$ berechnen. Die Ergebnisse sind in Tabelle 9 zusammengefasst.

Tabelle 9: Einfluss der Oxidationsmitteläquivalente auf die Leitfähigkeit nach Waschen von PEDOT:Tos und Additivzugabe

| Eintrag | $FeTos_3$ [Äq.] | Schichtdicke [$\mu$m] | Leitfähigkeit [S/cm] | Seebeck [$\mu$V/K] | $\alpha^2\sigma$ [pW/m$K^2$] |
|---|---|---|---|---|---|
| 1 | 2.0 | 2.8 | 60.3 | 11.5 | 0.08 |
| 2 | 2.15 | 3.2 | 68.1 | 12.1 | 0.10 |
| 3 | 2.20 | 4.5 | 71.3 | 11.7 | 0.10 |
| 4 | 2.22 | 1.5 | 101.1 | 11.1 | 0.12 |
| 5 | 2.25 | 2.5 | 114.8 | 10.6 | 0.13 |
| 6 | 2.30 | 3.7 | 89.5 | 11.2 | 0.12 |

Der nahezu konstant bleibende Seebeck-Koeffizient, der eigentlich dotierungsabhängig ist, überrascht. Eine Erklärung wäre die hohe Reaktivität von BiEDOT. Es könnte so schnell PEDOT entstehen, welches sofort die maximale Dotierung aufnimmt. Diese Vermutung wird durch das Dotierungsexperiment mit 2.00 Äquivalenten gestützt. Bei diesem Verhältnis müsste neutrales, halbleitendes PEDOT mit sehr schlechter Leitfähigkeit von unter $10^{-1}$ S/cm entstehen. Da dies offensichtlich nicht der Fall ist, kann ab einem gewissen Polymerisationsgrad eher Dotierung als oxidatives Kettenwachstum beobachtet werden. Dementsprechend ist nahezu kein Einfluss auf den "powerfactor" $\alpha^2\sigma$ festzustellen (Tabelle 9, Einträge 1 bis 6).

Beispiel 12

Um die Viskosität von PEDOT:Tos zu überprüfen, wurde das kommerziell erhältliche S V4 von Clevios™, welches für Siebdruck optimiert ist, auf dessen rheologischen Eigenschaften hin untersucht. Um für Siebdruck tauglich zu sein, muss das Druckfluid scherverdünnend sein, d.h. es sollte bei hohen Scherkräften eine niedrigere Viskosität aufweisen. Zuerst wurde S V4 direkt mit dem PEDOT:Tos-Gemisch verglichen. Das Ergebnis der Messungen ist in Figur 1 dargestellt.

Figur 1 zeigt die scherratenabhängige Viskosität von siebdruckfähigem Clevios™ S V4 (links) im Vergleich mit dem PEDOT:Tos-Gemisch vor den Aufreinigungsschritten (rechts).

Das PEDOT:Tos-Gemisch weist eine hohe Scherverdünnung auf, verhält sich also wie ein nichtnewtonsches Fluid. Somit sollte bereits das erhaltene PEDOT:Tos-Gemisch für den Siebdruck geeignet sein. Wie schon diskutiert wäre ein anschließender Waschschritt der gedruckten Schicht jedoch unpraktikabel. Deshalb wurden auch das "reine" PEDOT:Tos und das druckfertige PEDOT:Tos rheologisch untersucht (Figur 2).

Figur 2 zeigt die Viskosität von "reinem" PEDOT:Tos und druckfertigem PEDOT:Tos in Abhängigkeit von der Scherrate.

Interessanterweise weist das "reine" PEDOT:Tos ohne zusätzliche Additive ebenfalls eine Scherratenverdünnung auf. Auffällig ist die sehr hohe anfängliche Viskosität ($10^8$ mPa s), die auf das Abfiltrieren des Lösungsmittels zurückzuführen ist, somit ist das "reine" PEDOT:Tos sehr konzentriert und klumpig. Nach Verdünnung mit etwas Isopropanol und PEO-Additivs ($M_v$~100.000) sinkt die anfängliche Viskosität (107 mPa s) wieder ab. Alle gemessenen Proben weisen ebenso wie Clevios™ S V4 eine Scherratenverdünnung auf und sind für den Siebdruck geeignet.

Beispiel 13

Um die Siebdruckfähigkeit von PEDOT:Tos zu überprüfen wurden Druckversuche auf einer Siebdruckapparatur durchgeführt. Damit sind Nassfilmschichtdicken von ca. 300 µm möglich. Die gedruckten Quadrate haben eine Größe von 1 x 1 cm (Figur 3). Das Sieb ist auf einen quadratischen Stahlrahmen gespannt. Durch Auftragen der Druckpaste und anschließendem Durchdrücken mit einem abgerundeten geraden Plastikstück wurde die Druckpaste auf das Glas- oder Plastiksubstrat übertragen. Die Viskosität der PEDOT:Tos-Mischungen wurde jeweils durch Zugabe von Isopropanol eingestellt und über Testdrucke auf deren Tauglichkeit hin überprüft. Der entstandene Nassfilm wurde mit Hilfe einer Heizpistole für 5 - 15 s getrocknet.

Figur 3 zeigt einen Siebdruck für Testdrucke (links) und eine vergrößerte Darstellung eines Siebdruckquadrats (rechts).

Durch die Testdrucke wurde gezeigt, dass die angefertigten PEDOT:Tos-Formulierungen siebdruckfähig sind und einen niedrigen Flächenwiderstand aufweisen. Somit sollte die PEDOT-Druckpaste im großen Maßstab verdruckbar sein. Die benötigten Fluidmengen für ein Siebdruckquadrat belaufen sich auf ca. 0.2 - 0.5 mL.

Beispiel 14

Für einen Test-Druckansatz auf einer in den Einrichtungen des Innovationlab vorhandenen Rolle-zu-Rolle Druckmaschine werden etwa 100 bis 200 mL Druckpaste benötigt. Dies erfordert 9.2 g BiEDOT; bezogen auf die bisherigen Polymerisationen entspricht das einem 450-fachen Ansatz im Vergleich zu den 20 mg BiEDOT-Experimenten. Dazu wurde 49 g Eisen(III)-tosylat in 210 mL einer Anisol-Isopropanol-Mischung (1:1 Gew/Gew) gelöst. BiEDOT wurde in 185 mL Anisol-Isopropanol (87:13 Gew/Gew) gelöst. Beiden Lösungen wurden je 2.3 g PEO ($M_v$~100.000) und 2.3 g PEGME ($M_n$~2000) zugegeben. Für die Polymerisation wurde die BiEDOT-Lösung unter rühren zur Eisen(III)-tosylat-Lösung gegeben. Die Polymerisation verlief unproblematisch und ohne Hitzentwicklung und ermöglicht somit weiteres Aufskalieren. Nach 5 min war in der viskosen Masse keine gelbe Eisen(III)-Lösung mehr zu beobachten, die Polymerisation ist abgeschlossen und 1 L einer Ethylenglykol-Wasser-Mischung (1:1) wurde zugegeben.

Die Waschlösung wurde 1 h gerührt und anschließend über einen großen Filter abfiltriert. Das überstehende Anisol wurde teilweise mit einer Pipette abgetrennt. Nach Filtration wurde der Filterkuchen in ein Transportgefäß überführt und es wurden 500 mg PEO ($M_v$ 100.000) in 20 mL Anisol zugegeben und verrührt. Aus 9.2 g BiEDOT wurden so 238

g Druckpaste erhalten; dies entspricht einem PEDOT-Gehalt von ca. 3.4 Gew.-%.

Die PEDOT-Druckpaste wurde mit Hilfe zweier 100 mL-Spritzen in die Siebdruckwalze der Druckmaschine gegeben. Es wurde eine 1,4 $\mu$m dicke Poly(ethylennaphthalat)-Folie (PEN-Folie) bedruckt, die durch eine 100 $\mu$m dicke Poly(ethylenterephthalat)-Trägerfolie (PET-Folie) verstärkt wurde. Auf der PEN-Folie waren bereits strukturierte Silberkontakte aufgedruckt. Die Trocknung des gedruckten PEDOTs wurde durch einen fest installierten Heißluft- und IR-Trockner sichergestellt. Zusätzlich wurde mit einer vom Karlsruher Institut für Technologie entwickelten Trocknungsapparatur für vollständige Trocknung gesorgt.

Im Vergleich zu Clevios™ S V4 von Heraeus verlief die Trocknung mit dem druckfertigen PEDOT:Tos deutlich schneller und die PEDOT-Felder waren schon nach der ersten Trocknungssequenz der Druckmaschine wischfest auf der Folie getrocknet. Diese schnell trocknende Eigenschaft macht eine schnellere Laufgeschwindigkeit der Folie möglich und somit könnte mehr Folie innerhalb der gleichen Zeit bedruckt werden. Die vollständige Trocknung aller aufgedruckten PEDOT-Felder ist nötig um die bedruckte Folie aufrollen zu können. Nicht getrocknete Stellen verkleben mit der darüber liegenden Folie und führen zu irreversiblen Defekten der thermoelektrischen Generatoren.

Die eingesetzte Menge an PEDOT:Tos reichte nicht aus um die Folie auf der kompletten Breite zu bedrucken (330 mm) (Figur 4). Es konnten jedoch einzelne funktionsfähige Felder gedruckt werden, deren Flächenwiderstand gemessen wurde. Die Werte schwankten je nach Druckqualität des ausgewählten Feldes zwischen 100 und 140 $\Omega/cm^2$.

Figur 4 zeigt ausgewählte Bereiche der durch die Forschungsdruckmaschine mit PEDOT:Tos und Silberelektroden bedruckten 1.4 $\mu$m dicken Folie.

Das "Ausfransen" der gedruckten PEDOT-Streifen (Figur 4, rechts) ist auf überstehendes Anisol zurückzuführen, das bei der Extraktion nicht komplett abgetrennt wurde. Auch war anfänglich die Viskosität des Fluids nicht optimal und es musste mit Isopropanol verdünnt werden, um ein besseres Druckbild zu erhalten.

Durch die Aufskalierung der Polymerisation und der anschließenden Verwendung der Druckpaste auf einer Rolle-zu-Rolle-Druckmaschine wurde der Weg hin zu vollständigen TEGs geebnet. Für eine auf kompletter Breite bedruckten Folie wird ca. 1 kg der Druckpaste benötigt, was dem 4-fachen der für diesen Testdruck verwendeten Menge entspricht.

**Patentansprüche**

1. Verfahren zur Herstellung einer Druckpaste enthaltend Poly(3,4-ethylendioxythiophen)-tosylat durch Polymerisation von Bis(3,4-ethylendioxythiophen) in Gegenwart von Eisen(III)-tosylat in einem organischen Lösungsmittel.

2. Verfahren nach Anspruch 1, **dadurch gekennzeichnet, dass** das organische Lösungsmittel Anisol enthält.

3. Verfahren nach Anspruch 2, **dadurch gekennzeichnet, dass** das organische Lösungsmittel ein Anisol-Isopropanol-Gemisch ist.

4. Verfahren nach einem der Ansprüche 1 bis 3, **dadurch gekennzeichnet, dass** dem Poly(3,4-ethylendioxythiophen)-tosylat ein polymeres Bindemittel als filmbildendes Additiv zugegeben wird.

5. Verfahren nach Anspruch 4, **dadurch gekennzeichnet, dass** das polymere Bindemittel ein Polyethylenoxid ist.

6. Verfahren nach einem der Ansprüche 1 bis 5, **dadurch gekennzeichnet, dass** das Reaktionsgemisch der Polymerisation anschließend mit einem Extraktionsmittel extrahiert wird.

7. Verfahren nach Anspruch 6, **dadurch gekennzeichnet, dass** das Extraktionsmittel ein Ethylenglykol-Wasser-Gemisch ist.

8. Verfahren nach einem der Ansprüche 1 bis 7 mit den Schritten

   (i) Polymerisation von Bis(3,4-ethylendioxythiophen) in Gegenwart von Eisen(III)-tosylat in einem organischen Lösungsmittel,
   (ii) Extraktion des in Schritt (i) erhaltenen Reaktionsgemischs mit einem Extraktionsmittel,
   (iii) Abtrennung von Poly(3,4-ethylendioxythiophen)-tosylat von dem in Schritt (ii) erhaltenen Gemisch als Feststoff,
   (iv) Zugabe eines polymeren Bindemittels und gegebenenfalls eines weiteren organischen Lösungsmittels.

9. Verfahren nach Anspruch 8, **dadurch gekennzeichnet, dass** in Schritt (iii) Poly(3,4-ethylendioxythiophen)-tosylat

durch Filtration als Feststoff abgetrennt wird.

**10.** Verfahren nach Anspruch 9, **dadurch gekennzeichnet, dass** das in Schritt (iv) zugegebene Bindemittel ein Polyethylenoxid und das weitere organische Lösungsmittel Isopropanol ist.

**11.** Druckpaste enthaltend

a) 1 bis 7 Gew.-% Poly(3,4-ethylendioxythiophen)-tosylat,
b) 0,01 bis 2 Gew.-% eines polymeren Bindemittels als filmbildendes Additiv,
c) 81 bis 98,99 Gew.-% eines organischen Lösungsmittels,
d) 0 bis 10 Gew.-% weiterer Bestandteile.

**12.** Druckpaste nach Anspruch 11, **dadurch gekennzeichnet, dass** das polymere Bindemittel b) ein Polyethylenoxid ist.

**13.** Druckpaste nach Anspruch 11 oder 12, **dadurch gekennzeichnet, dass** das organische Lösungsmittel c) Isopropanol ist.

**14.** Verwendung einer Druckpaste nach einem der Ansprüche 11 bis 13 zur Herstellung von leitfähigen Filmen für thermoelektrische Generatoren.

**15.** Verwendung nach Anspruch 14, **dadurch gekennzeichnet, dass** zur Herstellung der leitfähigen Filmen die Druckpaste mittels Siebdruck auf ein Substrat aufgebracht wird.

Figur 1

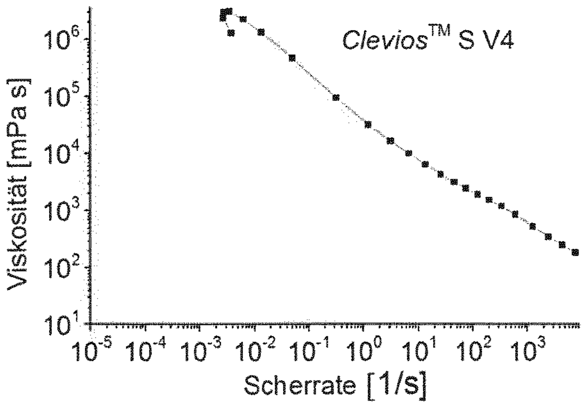


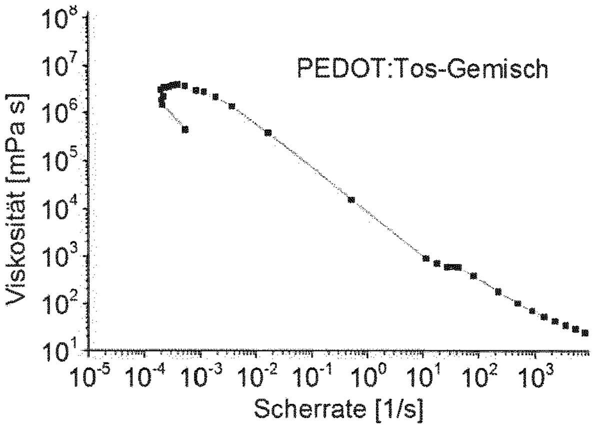


Figur 2

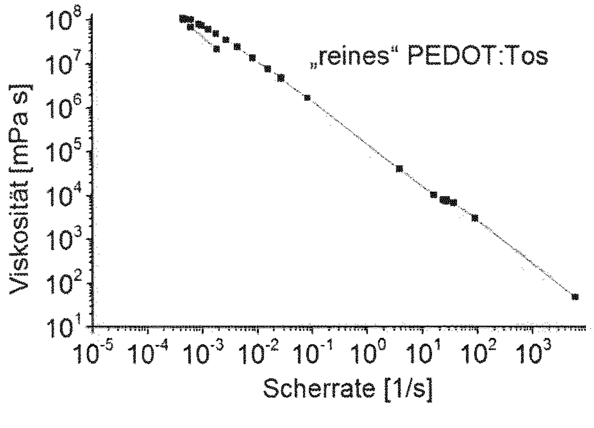


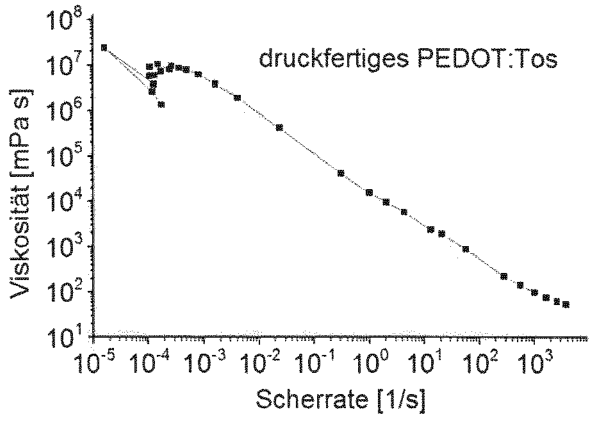

Figur 3

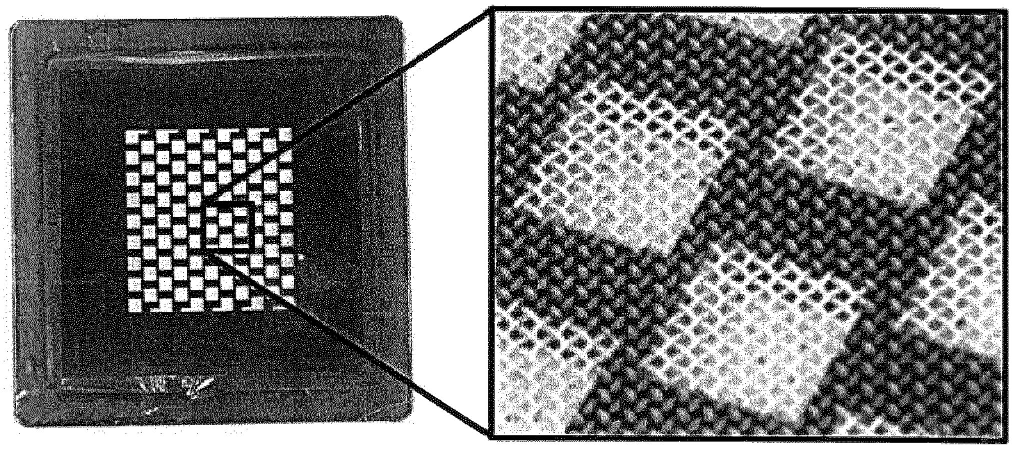

Figur 4

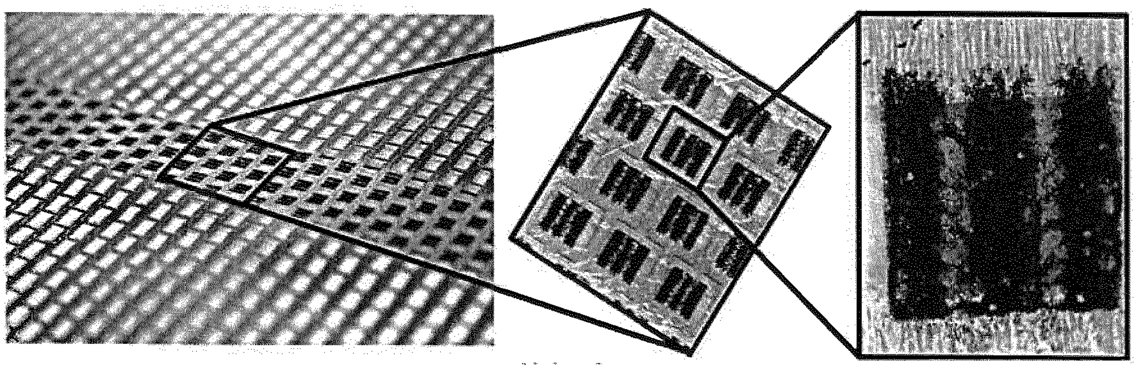

Europäisches Patentamt
European Patent Office
Office européen des brevets

# EUROPÄISCHER RECHERCHENBERICHT

Nummer der Anmeldung
EP 17 19 8596

| EINSCHLÄGIGE DOKUMENTE | | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (IPC) |
| X | WO 2017/059845 A1 (ASLAN SILAS MEHMET [DE]) 13. April 2017 (2017-04-13)<br>* Seite 11, Zeile 1 - Seite 24, Zeile 30; Ansprüche 1-18; Beispiele 1-6 *<br>----- | 1-15 | INV.<br>H01L51/00<br>H01L35/24<br>C08G61/12 |
| | | | RECHERCHIERTE SACHGEBIETE (IPC) |
| | | | H01L<br>C08G |

Der vorliegende Recherchenbericht wurde für alle Patentansprüche erstellt

1

| Recherchenort | Abschlußdatum der Recherche | Prüfer |
|---|---|---|
| Den Haag | 26. April 2018 | Konrádsson, Ásgeir |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR.

EP 17 19 8596

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

26-04-2018

| Im Recherchenbericht angeführtes Patentdokument | Datum der Veröffentlichung | Mitglied(er) der Patentfamilie | Datum der Veröffentlichung |
|---|---|---|---|
| WO 2017059845 A1 | 13-04-2017 | DE 102015117207 A1 | 13-04-2017 |
| | | WO 2017059845 A1 | 13-04-2017 |

EPO FORM P0461

Für nähere Einzelheiten zu diesem Anhang : siehe Amtsblatt des Europäischen Patentamts, Nr.12/82

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- EP 7074401994 A, G. D. Wolff, J. F., R. Schomaecker
- EP 0686662 A2
- US 6323309 B1, T. M. Swager, R. Kingsborough, S. S. Zhu
- US 6323309 B


### In der Beschreibung aufgeführte Nicht-Patentliteratur


- **R. C. MORENO ; B. A. JAMES ; A. NAVID ; L. PILON.** *Int. J. Heat and Mass Tran.,* 2012, vol. 55, 4301
- **F. Y. LEE ; A. NAVID ; L. PILON.** *Appl. Therm. Eng.,* 2012, vol. 37, 30
- **M. SCHOLDT ; H. DO ; J. LANG ; A. GALL ; A. COLSMANN ; U. LEMMER ; J. KOENIG ; M. WINKLER ; H. BOETTNER.** *J. Electron. Mater.,* 2010, vol. 39, 1589
- **A. ELSCHNER ; S. KIRCHMEYER ; W. LOVENICH ; U. MERKER ; K. REUTER.** PEDOT: principles and applications of an intrinsically conductive polymer. CRC Press, 2010
- **S. G. IM ; D. KÜSTERS ; W. CHOI ; S. H. BAXAMUSA ; M. C. M. VAN DE SANDEN ; K. K. GLEASON.** *ACS Nano,* 2008, vol. 2, 1959
- **J. XIA ; N. MASAKI ; M. LIRA-CANTU ; Y. KIM ; K. JIANG ; S. YANAGIDA.** *J. Phys. Chem. C,* 2008, vol. 112, 11569
- **M. VOSGUERITCHIAN ; D. J. LIPOMI ; Z. BAO.** *Adv. Funct. Mater.,* 2012, vol. 22, 421
- **G. KIM ; L. SHAO ; K. ZHANG ; K. P. PIPE.** *Nat. Mater.,* 2013, vol. 12, 1
- **S. JÖNSSON ; J. BIRGERSON ; X. CRISPIN ; G. GRECZYNSKI ; W. OSIKOWICZ ; A. DENIER ; VAN DER GON ; W. SALANECK ; M. FAHLMAN.** *Synthetic Met.,* 2003, vol. 139, 1
- **B. WINTHER-JENSEN ; K. WEST.** *Macromolecules,* 2004, vol. 37, 4538
- **B. WINTHER-JENSEN ; D. W. BREIBY ; K. WEST.** *Synthetic Met.,* 2005, vol. 152, 1
- **M. FABRETTO ; M. MÜLLER ; K. ZUBER ; P. MURPHY.** *Macromol. Rapid Commun.,* 2009, vol. 30, 1846
- **O. BUBNOVA ; Z. U. KHAN ; A. MALTI ; S. BRAUN ; M. FAHLMAN ; M. B. X. CRISPIN.** *Nat. Mater.,* 2011, vol. 10, 429
- **T. PARK ; C. PARK ; B. KIM ; H. SHIN ; E. KIM.** *Energ. Environ. Sci.,* 2013, vol. 6, 788
- **G. A. SOTZING ; J. R. REYNOLDS ; P. J. STEEL.** *Adv. Mater.,* 1997, vol. 9, 795